# EUROPEAN PATENT SPECIFICATION

(11) **EP 3 379 664 B1**
(45) Date of publication and mention of the grant of the patent: **14.06.2023**
(21) Application number: 17305301.8
(22) Date of filing: 20.03.2017
(51) Int. Cl.: H01S 5/0625, H01S 5/14, H01S 3/10, H01S 3/105, H01S 5/028

(54) **A LASER AND METHOD OF CONTROLLING A LASER TO OUTPUT A SIGNAL INTERMITTENTLY**
LASER UND VERFAHREN ZUR STEUERUNG EINES LASERS ZUR AUSGABE EINES PERIODISCHEN SIGNALS
LASER ET PROCÉDÉ DE COMMANDE D'UN LASER POUR ÉMETTRE UN SIGNAL DE MANIÈRE INTERMITTENTE

(43) Date of publication of application: 26.09.2018
(73) Proprietor: Nokia Solutions and Networks Oy, 02610 Espoo (FI)
(72) Inventor: DEBREGEAS, Helene, 91767 Palaiseau (FR); BARBET, Sophie, 91767 Palaiseau (FR); BRENOT, Romain, 91767 Palaiseau (FR); PROVOST, Jean-Guy, 91767 Palaiseau (FR)
(74) Representative: Script IP Limited

(56) References cited:
- EP-A2- 1 304 778
- GB-A- 2 437 593
- US-A- 5 572 543
- LEVI A F J ET AL: "MULTIELECTRODE QUANTUM WELL LASER FOR DIGITAL SWITCHING", APPLIED PHYSICS LETTERS, A I P PUBLISHING LLC, US, vol. 56, no. 12, 19 March 1990 (1990-03-19), pages 1095-1097, XP000133461, ISSN: 0003-6951, DOI: 10.1063/1.102578

## Description

### FIELD OF THE INVENTION

The field of the invention relates to lasers and in particular to lasers configured to intermittently output signals.

### BACKGROUND

Emerging NGPON2 systems (next generation passive optical networks) use both time and wavelength division multiplexing (TWDM) when transmitting signals. The time division multiplexing is generated by operating multiple distributed feedback (DFB) laser sources in burst mode, such that each laser only transmits signals during its own time period.

One problem with operating in burst mode particularly in systems which also use wavelength division multiplexing is the drift in wavelength that can occur due to temperature changes in the laser during the bursts. In this regard the driving current driving the laser during the bursts will provide some heating to the laser which can cause wavelength drift. Lasers for example, which use a Bragg grating to define the wavelength are particularly susceptible to changes in the effective index resulting in changes in the wavelength due to temperature changes.

Wavelength division multiplexing systems need to be able to separate the different signals and use wavelength selective elements such as arrayed wavelength gratings AWG to do this. Where wavelengths get misaligned with the AWG transmission spectrum a first effect is a reduction in output power and a further effect is the pollution of adjacent channels. In this regard for NGPON2 applications with 100GHZ or 50GHz spaced channels, any wavelength drift should remain below 20GHz for 100GHz spacing or 10GHz for 50 GHz spacing.

Various solutions have been proposed to address this issue. One solution is to reduce self-heating by reducing the laser current modulation range, but this is at the expense of output power. Another approach termed "counter heating" consists in using a heater along the laser waveguide and applying a voltage to the heater in antiphase to the bursts such that the heat generated around the laser is maintained at a fairly constant level over time leading to a reduction in wavelength drift.

It would be desirable to provide a laser operable to provide output optical signals intermittently while reducing variations in laser cavity temperature.

"Multielectrode Quantum Well laser For Digital Switching" by Levi et al, Applied Physics Letters 56 (1990) 1095-1097discloses a quantum well laser for digital switching in which a Fabry-Perot cavity has two absorbing sections. A data stream is applied to one section and a demultiplexer signal to the other. The laser acting as an AND gate, so that when both the input signals are high the laser outputs a signal, otherwise one or other of the absorption sections prevents the signal from being output. Thus, one absorbing section acts to modulate the laser to provide the data signal and the other to turn it off or on to output or demultiplex a portion of the signal.

EP1304778 A2 discloses a blue laser which comprises an absorbing section, a modulated signal being generated by applying the modulating signal to the absorbing section which when absorbing prevents the laser from outputting a signal.

GB2437593 A discloses a semiconductor laser that changes the reflectivity of one of the reflectors of the laser cavity to modulate the output signal. In this document the absorber is outside the laser cavity, and is used to control the equivalent reflectivity of the antiresonant Fabry-Perot cavity.

US5572543 A discloses a system where a mirror is tilted periodically to switch off the laser and generate Q switching.

### SUMMARY

The present invention provides a device and a method as defined in the independent claims. Preferred embodiments are defined in the dependent claims.

The inventors of the present invention recognised that the generation of a laser signal from a laser requires the gain experienced by the optical signal within the laser cavity due to amplification in the active or gain section to exceed the losses that are experienced by the signal as it is reflected between the end cavity surfaces. In effect there is a threshold at which the cumulative gain and loss is sufficient for lasing effects and below which no lasing effects occur.

Conventionally lasers have been controlled to operate intermittently, such as in burst mode, by providing intermittent amplification of the optical signal with an intermittent driving signal. Where this driving signal is sufficient to amplify the signal enough such that the gains experienced by the optical signal in the resonant cavity exceed the threshold value required for lasing then the laser is turned on, when the driving signal drops below this the laser turns off.

The inventors of the present invention recognised that an alternative way of controlling the intermittent operation of a laser without needing to change the driving signal would be to change the losses experienced by the optical signal within the resonant cavity. An advantage of this is that the driving signal supplies power to the laser and it is this that may cause the laser to heat up. Where the driving signal is intermittent then the heating is intermittent and the laser experiences temperature changes. These changes in temperature can be disadvantageous causing changes in the output wavelength of the laser.

If the lasing cavity were to be provided with a controllable optical loss section the losses experienced by the optical signal within the resonant cavity could be controlled and where they were increased to above the gains experienced by the optical signal due to amplification by a driving signal, then lasing effects would be supressed and the laser would no longer output an optical signal. In this way a signal can be output or not in dependence upon the state of the optical loss section rather than on the level of a driving signal. As lasing effects occur at a threshold value, changes in optical losses that take the signal either above or below the threshold are all that is required to effectively turn the output signal off and on, thereby providing a controllable laser whose operation temperature is substantially independent of whether it is currently outputting a signal.

One advantage of controlling the output of the laser using control of the absorption section is that the power supplied to the laser may be maintained at a constant average level even where the output of the laser is intermittent. In many lasers the output optical signal is sensitive to temperature variations, these causing variations in the wavelength output. This can be a particular problem where a laser is being used in a time division and wavelength division multiplexed system, where individual lasers are used to output signals in particular time periods and at particular wavelengths. These WDM systems contain multiplexers such as arrayed waveguide gratings AWG, which are wavelength selective. If there is wavelength drift, then the signal may no longer be aligned with the maximum of the AWG transmission leading to high losses and a transmission penalty. By maintaining the power supplied to the resonant cavity to be substantially constant variations in wavelength due to variations in temperature can be avoided or at least reduced.

Where the modulation of the signal is generated by the driving current control circuitry, then clearly this will vary as the signal is modulated. However, the average electrical power supplied to the active section is controlled to be substantially constant both during the output of the modulated optical signal and when no optical signal is output. Therefore, the modulation range and average power supplied during any period where no signal is output is selected such that the average electrical power supplied to the laser cavity is substantially constant.

Although the laser may be formed in a number of different ways, in some embodiments the laser comprises a semiconductor laser. Semiconductor lasers comprise active sections formed of an active material that amplifies optical signals in response to a driving current. They are susceptible to heating due to that driving current and where they are operating in an intermittent mode such as a burst mode and this heating is intermittent, they may experience problems such as wavelength or frequency drift. Thus, they are particularly applicable to improvements provided by embodiments of the invention.

The controllable loss section may be formed in a number of ways such as by a moveable mirror forming one reflecting surface of the optical cavity and operable to move between a position where the light is reflected back to the other end of the cavity and a position where it is deflected from the return path. Alternatively it may be formed by some form of a movable shield operable to intercept the beams reflecting between the surfaces. In other embodiments said controllable optical loss section comprises an absorbing section, said absorbing section being configured to absorb optical energy of a wavelength of said optical signal when in said high optical loss mode and to transmit optical energy of said wavelength of said optical signal when in said lower optical loss mode.

One embodiment provides a laser configured to output an optical signal, said laser comprising: a resonant cavity; said resonant cavity comprising a laser section comprising an active material operable to amplify said optical signal in response to a driving current and a controllable absorbing section, said controllable absorbing section being configured to absorb optical energy of a wavelength of said optical signal when in absorbing mode and to transmit optical energy of said wavelength of said optical signal when in transmitting mode; and a control signal input operable to supply a control signal to said absorbing section to control said absorbing section to periodically transition between said absorbing and transmitting modes, a lasing effect of said resonant cavity being suppressed by absorption of said optical energy when said absorbing section is in said absorbing mode, such that said transitioning of modes of said absorbing section causes said laser to periodically output said optical signal.

One effective way of controlling the optical losses is to provide the laser cavity with an absorbing section. An absorbing section that is controllable to operate in either an absorbing mode in which it absorbs optical energy of the optical signal or a transmitting mode in which it transmits or even amplifies the optical signal can be used to provide effective control of the losses.

In some embodiments, said absorbing section comprises a semiconductor optical amplifier, said semiconductor optical amplifier being configured to switch between absorbing mode and transparent mode in response to said control signal.

Although the absorbing section can be formed in a number of ways provided that it is controllable to switch between an absorbing mode where sufficient optical energy is absorbed to suppress the lasing effect and a lower loss transparent mode, in some cases a semiconductor optical amplifier is used. These are compatible with many semiconductor lasers and can be simply integrated into the resonant cavity, providing effective, simple and power efficient control of the lasing effect within the cavity. In this regard their absorption properties are good such that a relatively small portion of the optical cavity will be sufficient to provide an absorbing section operable to provide the desired effects.

In some embodiments, said absorbing section is formed of a same material as said material of said active section, said absorbing section being reverse biased when in absorbing mode.

A semiconductor optical amplifier may advantageously be formed of the same material as the active section of the laser. Reverse biasing this section makes the section act to absorb optical signals of the wavelength that would otherwise be transmitted or even amplified by the device. Forming it of the same material in this way makes its manufacture and control straightforward and provides an absorbing section that operates at the wavelengths of the optical signal amplified in the resonant cavity.

Although the absorbing section simply needs to be able to transmit the signal when not in absorbing mode, in some embodiments, it is configured to amplify the optical signal when in transmitting mode.

The use of a semiconductor optical amplifier as the absorbing section also provides the possibility of providing amplification of the transmitted signal when in lower loss mode. This amplification requires a forward biased voltage to provide a driving current, and thus, whether or not amplification is provided can be selected in dependence upon the requirements, power consumption and output signal level, of the laser.

In some embodiments, said laser further comprises an electrically insulating section, said active section and said absorbing section being separated by said electrically insulating section such that an electrical signal input to one of said laser or absorbing section is insulated from the other section.

Where the absorbing section is formed of a similar or same semiconductor material as the active section then in order to provide separate control to each section and avoid the control signals affecting the other section, an insulating section between the two sections can be provided. This can be done by simple implantation of for example H⁺ ions into the semiconductor material between the two sections to nullify the dopant, alternatively the insulation section may be provided using etching to provide the electrical isolation.

In some cases, the active section of the laser may comprise a Bragg grating, the pitch of the Bragg grating providing the wavelength selection for the laser. Such lasers are susceptible to wavelength drift as the effective index of the grating will change as the temperature changes, which will lead to a change in the wavelength. Thus, lasers that comprise Bragg gratings are particularly applicable to improvements of embodiments. Embodiments comprise distributed feedback lasers which comprise these Bragg gratings within the active portion.

In some embodiments, said resonant cavity comprises two active sections separated by said absorption section.

In some embodiments, said two active sections each comprise a Bragg grating.

In some embodiments, said resonant cavity further comprises a wavelength selective reflecting portion.

One type of laser is a tuneable laser such as a distributed Bragg reflector laser where the resonant cavity comprises a wavelength selective reflecting portion in addition to the active section and the absorbing section. The wavelength selective reflecting portion allows the laser to be tuned by changing the wavelength that is reflected. This wavelength selective portion may be a Bragg grating or a plurality of Bragg gratings. In this type of laser the gratings are not within the active section itself but are outside of it. In this regard the wavelength selective reflective portion may be formed in a number of different way such as with a plurality of sampled gratings, or ring resonators, or Fabry-Perot cavities (blades in free space, between on-chip mirrors on InP), the Vernier effect between the successive filters (rings or Fabry-Perot) providing the wavelength selective reflection.

In some embodiments in addition to said wavelength selective reflecting portion, said laser comprises a phase selecting section.

A phase selecting section can be used to tune the laser such that the phase of the resonant cavity is aligned with the wavelength of the wavelength selective reflecting portion. The cavity may have a plurality of Fabry-Perot modes that it may resonate at and it is important that the resonant mode is aligned with the wavelength selective reflective portion, which may be a grating, for the laser to operate effectively. The phase selecting section acts to align the phase of the mode such that one of the modes aligns with the reflecting portion. The phase selecting section is a section where a current is injected into the section to change the refractive index of the section such that the resonant wavelength is altered slightly to align it with the wavelength selective reflecting portion. In such a tuneable laser, as can be appreciated, changes in temperature may be sufficient to switch the resonant mode that the cavity is resonating at, such that it no longer aligns with the wavelength selective reflecting portion. Thus in these lasers, as with the distributed feedback laser, it may be advantageous to maintain a relatively constant temperature and provide an intermittent mode by changing the optical loss properties rather than changing the driving current. In this way the drive current to the active section remains substantially constant while the optical loss section controls the switching on and off of the laser which leads to limited thermal impact. This leads to the phase condition of the cavity remaining stable when the laser is turned on.

The laser comprises control circuitry for controlling said control signal supplied to said optical loss section, said control circuitry being configured to generate a periodically varying control signal to periodically switch said optical loss section from said lower loss mode to said high loss mode such that said laser operates in a burst mode.

Control of the optical loss section is used to provide laser operation in burst mode. It is in burst mode that temperature changes can be particularly challenging and thus, providing a laser where burst mode is controlled by optical losses and not by a driving current has many advantages.

### BRIEF DESCRIPTION OF THE DRAWINGS

Embodiments of the present invention will now be described further, with reference to the accompanying drawings, in which:
Figure 1a illustrates a distributed feedback laser according to an embodiment;
Figure 1b illustrates a distributed feedback laser according to a further embodiment;
Figure 2 illustrates the driving current and absorption control signal during burst mode operation of a laser according to an embodiment;
Figure 3 illustrates a tunable laser according to an embodiment; and
Figure 4 illustrates a laser according to a further embodiment.

### DESCRIPTION OF THE EMBODIMENTS

Before discussing the embodiments in any more detail, first an overview will be provided.

In order to reduce temperature fluctuations in lasers that output optical signals intermittently such as in burst mode, a laser that has a substantially constant average electrical power applied to the laser section is provided. This allows the temperature of the laser section which may comprise, a grating, to remain stable, with no self-heating occurring at the beginning of bursts.

Laser extinction between optical signal output is provided by an optical loss section which may comprise an absorbing section positioned inside the laser cavity, used as an internal switch to turn on the laser during bursts and to turn it off between the bursts.

If the absorbing section is outside the laser cavity, lasing effect occurs, and extinction is only provided by single propagation along the absorbing section, which struggles to exceed 40dB. Furthermore, this arrangement would require a long absorbing section and higher electrical consumption in the form of a negative Voltage. By providing the absorbing section inside the laser cavity output power can be totally turned off simply by applying a small voltage variation.

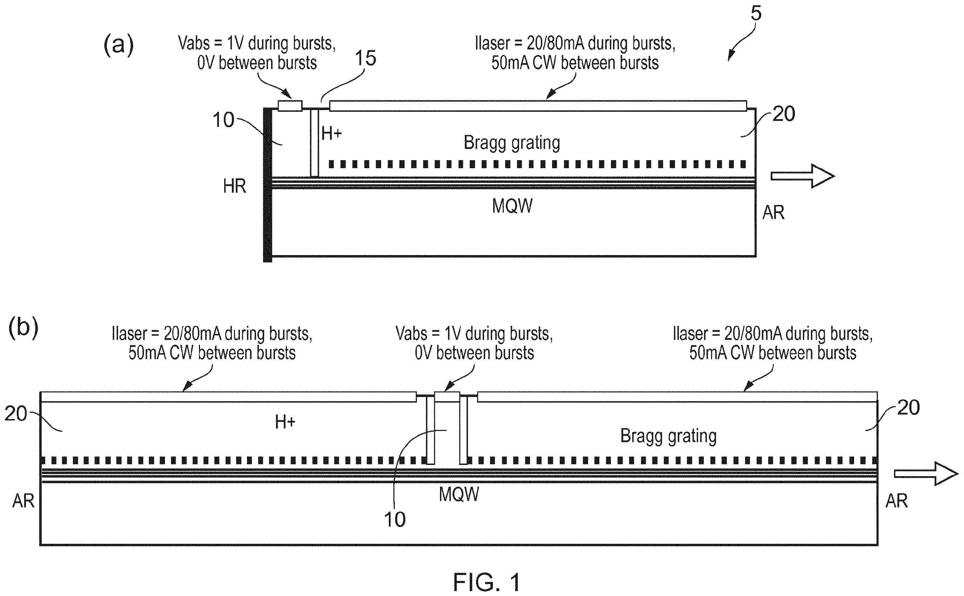

A laser of a first embodiment is illustrated Figure 1a. The laser 5 is composed of two sections 10, 20, electrically separated by an electrically insulating section 15 which in this embodiment is formed by H+ implantation. The two sections comprise an active or laser section 20, and an absorber section 10. The vertical structure is similar for both structures, with for example multi-quantum wells (MQW). The laser section 20 comprises a Bragg grating, which is used to select one single longitudinal mode.

Emitted wavelength is imposed by the laser section : λ = 2.n_{eff}.Λ with n_{eff} the effective index of laser section, and A the grating pitch.

In this embodiment, the front facet is antireflection coated (AR), while the back facet is high-reflection coated (HR), such that the oscillating laser cavity is defined between the grating and the back facet. The absorber is positioned between the laser section and the back facet that is inside the lasing or laser cavity.

In a standard laser without the absorbing section, the laser is turned on and off with the laser or driving current Iₗₐₛₑᵣ set below or under a threshold value. Part of the electrical injected power U.I is transformed into thermal power, leading to laser self-heating ΔT = Rₜₕ, U.I where Rₜₕ is the thermal resistance (°C/W), U is the voltage, and I the injected current. This temperature increase generates a modification of laser wavelength:
Δλ/ ΔT = 2 . Δn_{eff} / ΔT, typically 0.1nm/°C.

In the embodiment of Figure 1a, if current is injected in the laser section, say 80mA, then when the absorption section is under reverse polarization, say V_{abs}=0V, this section is very absorbing, cavity losses are high, no lasing occurs. When the absorption section is under direct polarization, say V_{abs}=1V, then this section is transparent or even has a slight gain, thus, cavity losses are low and lasing occurs.

But between these two situations, laser injected electrical power (R.I²) is constant, and as the power variation in the absorbing section is very limited, and distant from the grating section the lasing wavelength remains constant.

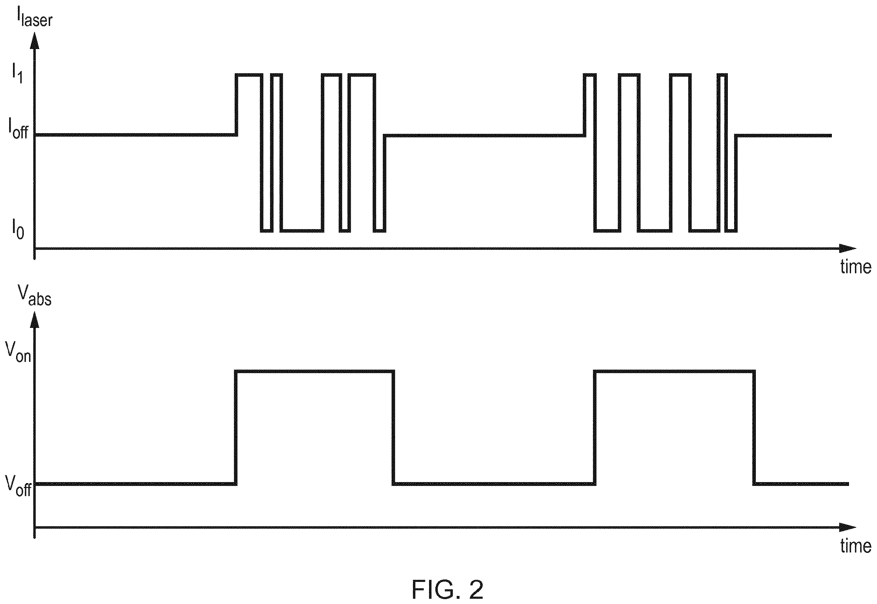

The operation in burst mode is illustrated figure 2:
- during bursts, the laser is modulated to transmit data, say between Io=20mA and I₁=80mA, leading to an electrical power of (U₀. I₀+U₁.I₁)/2. The absorption section is set at Vₒₙ around 1V to reach transparency, allowing lasing effect.
- between bursts, the laser is set to a continuous current I_{off} such that the electrical power is similar to electrical power during bursts: U_{off}. I_{off} = (U₀. I₀+U₁.I₁)/2. The absorption section is set at V_{off} around 0V to absorb light and prevent lasing oscillation.

Embodiments are based on the presence of an optical loss section, in the case of Figure 1a an absorber, inside the laser cavity. This can be turned to near transparency, transparency or slight amplification during bursts. In the first embodiment, the absorbing section is between the grating laser section and the reflective back facet. In another embodiment illustrated in Figure 1b, the absorbing section 10 is positioned between two active grating sections 20, possibly electrically connected. In this case, the rear facet is anti-reflection coated, and the cavity is defined by the two gratings.

Any other embodiment where an optical loss section such as an absorbing section is inside the cavity, and used to turn on and off the laser can be proposed.

The embodiments shown in Figures 1a and 1b have been illustrated with directly modulated lasers.

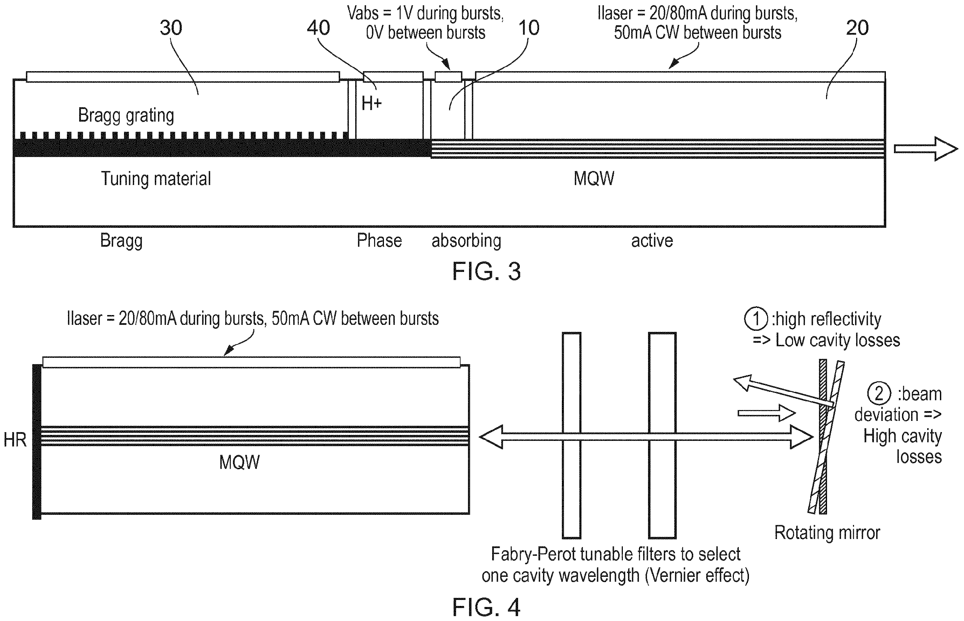

Figure 3 shows an alternative embodiment showing a tunable laser with the Bragg grating 30 being outside of the active section 20 and forming a wavelength selective reflector for this cavity. Absorbing section 10 controls the intermittent operation of the laser, while phase control section 40 controls the Fabry-Perot mode of resonance of the active section 20 to align it with the reflective wavelength. Modulation of the signal is provided by modulation of the driving current, however the Burst mode is controlled by the signal applied to the absorbing section 10.

Figure 4 shows an alternative way of providing intermittent control where one end of the laser cavity is formed by a controllable mirror. Tilting of the mirror provides the losses required for the optical losses for the cavity return trip to be less than the optical gain and thus, for lasing effects to be suppressed. In this case Fabry-Perot tunable filters are used to select the wavelength of the cavity using the Vernier effect.

A person of skill in the art would readily recognize that steps of various above-described methods can be performed by programmed computers. Herein, some embodiments are also intended to cover program storage devices, e.g., digital data storage media, which are machine or computer readable and encode machine-executable or computer-executable programs of instructions, wherein said instructions perform some or all of the steps of said above-described methods. The program storage devices may be, e.g., digital memories, magnetic storage media such as a magnetic disks and magnetic tapes, hard drives, or optically readable digital data storage media. The embodiments are also intended to cover computers programmed to perform said steps of the above-described methods.

The functions of the various elements shown in the Figures, including any functional blocks labelled as "processors" or "logic", may be provided through the use of dedicated hardware as well as hardware capable of executing software in association with appropriate software. When provided by a processor, the functions may be provided by a single dedicated processor, by a single shared processor, or by a plurality of individual processors, some of which may be shared. Moreover, explicit use of the term "processor" or "controller" or "logic" should not be construed to refer exclusively to hardware capable of executing software, and may implicitly include, without limitation, digital signal processor (DSP) hardware, network processor, application specific integrated circuit (ASIC), field programmable gate array (FPGA), read only memory (ROM) for storing software, random access memory (RAM), and non-volatile storage. Other hardware, conventional and/or custom, may also be included. Similarly, any switches shown in the Figures are conceptual only. Their function may be carried out through the operation of program logic, through dedicated logic, through the interaction of program control and dedicated logic, or even manually, the particular technique being selectable by the implementer as more specifically understood from the context.

The description and drawings merely illustrate the principles of the invention. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions.

## Claims

1. A laser, said laser comprising:
a resonant laser cavity;
said resonant laser cavity comprising a Bragg grating (30) the pitch of the Bragg grating providing the wavelength selection for the laser, at least one active section (20) comprising a material configured to amplify an optical signal in response to a driving current and a controllable optical loss section (10), said controllable optical loss section being controllable to transition between a high optical loss mode and a lower optical loss mode;
a control signal input configured to supply a control signal to said controllable optical loss section (10) to control said optical loss section (10) to transition between said high optical loss mode and said lower optical loss mode, a lasing effect of said resonant cavity being suppressed by optical losses when said optical loss section is in said high optical loss mode such that said transitioning of modes of said optical loss section causes said laser to transition between outputting said optical signal and outputting no optical signal; and
control circuitry configured to control said control signal supplied to said optical loss section, said control circuitry being configured to generate a periodically varying control signal to periodically switch said optical loss section from said lower loss mode to said high loss mode such that said laser operates in a burst mode, said control circuitry comprising driving current control circuitry configured to control said driving current supplied to said at least one active section such that an average electrical power supplied to said at least one active section is substantially the same during a period when said laser is not emitting said output signal and during a period when said laser is emitting said output signal; wherein
said laser comprises a directly modulated laser, said driving current control circuitry being configured to modulate said driving current such that said active section generates a modulated optical signal.

2. A laser according to claim 1, wherein said controllable optical loss section comprises an absorbing section, said absorbing section being configured to absorb optical energy of a wavelength of said optical signal when in said high optical loss mode and to transmit optical energy of said wavelength of said optical signal when in said lower optical loss mode.

3. A laser according to claim 2, wherein said absorbing section comprises a semiconductor optical amplifier, said semiconductor optical amplifier being configured to switch between a high optical loss, absorbing mode and a lower optical loss, transparent mode in response to said control signal.

4. A laser according to claim 3, wherein said absorbing section is formed of a same material as said material of said active section, said absorbing section being reverse biased when in absorbing mode.

5. A laser according to any one of claims 2 to 4, wherein said absorbing section is configured to amplify said optical signal in said lower optical loss mode.

6. A laser according to claim 1, wherein said controllable optical loss section comprises one of: a controllable tiltable mirror forming a reflective surface at one end of said resonant laser cavity and a controllable shielding portion for controllably inhibiting transmission of said optical signal within said resonant laser cavity.

7. A laser according to any preceding claim, wherein said at least one active section comprises said Bragg grating.

8. A laser according to any one of claims 1 to 7, wherein said resonant cavity further comprises a wavelength selective reflecting portion.

9. A laser according to claim 8, wherein said resonant cavity further comprises a phase selecting section.

10. A method of controlling an output of an optical signal from a laser comprising a resonant laser cavity, said resonant laser cavity comprising a Bragg grating (30) the pitch of the Bragg grating providing the wavelength selection for the laser, at least one active section (20) comprising a material configured to amplify an optical signal in response to a driving current and a controllable optical loss section (10), said controllable optical loss section being controllable to transition between a high optical loss mode and a lower optical loss mode; said method comprising:
supplying a driving current to said active section of said resonant cavity of said laser;
supplying a periodically varying control signal to the optical loss section (10) of said resonant cavity of said laser, said control signal controlling said optical loss section to periodically transition between a high loss and a lower loss mode, a lasing effect of said resonant cavity being suppressed by increased optical losses when said optical loss section is in said high loss mode such that said laser operates in a burst mode;
controlling said driving current supplied to said at least one active section such that an average electrical power supplied to said at least one active section is substantially the same during a period when said laser is not emitting said output signal and during a period when said laser is emitting said output signal; wherein
said laser comprises a directly modulated laser, said driving current control circuitry modulating said driving current such that said active section generates a modulated optical signal; wherein
said transitioning of modes of said optical loss section causes said laser to transition between outputting said optical signal and outputting no optical signal.

## Patentansprüche

1. Laser, wobei der Laser Folgendes umfasst:
einen resonanten Laserresonator;
wobei der resonante Laserresonator ein Bragg-Gitter (30), wobei die Teilung des Bragg-Gitters die Wellenlängenauswahl für den Laser bereitstellt, mindestens einen aktiven Bereich (20), der ein Material umfasst, das dazu ausgelegt ist, ein optisches Signal in Reaktion auf einen Ansteuerstrom zu verstärken, und einen steuerbaren optischen Verlustbereich (10) umfasst, wobei der steuerbare optische Verlustbereich steuerbar ist, zwischen einem hohen optischen Verlustmodus und einem geringeren optischen Verlustmodus überzugehen;
einen Steuersignaleingang, der dazu ausgelegt ist, dem steuerbaren optischen Verlustbereich (10) ein Steuersignal zuzuführen, um den optischen Verlustbereich (10) zum Übergehen zwischen dem hohen optischen Verlustmodus und dem geringeren optischen Verlustmodus zu steuern, wobei ein Lasereffekt des resonanten Resonators durch optische Verluste unterdrückt wird, wenn sich der optische Verlustbereich im hohen optischen Verlustmodus befindet, derart, dass das Übergehen von Modi des optischen Verlustbereichs den Laser veranlasst, zwischen dem Ausgeben des optischen Signals und dem Ausgeben von keinem optischen Signal überzugehen; und
eine Steuerschaltung, die dazu ausgelegt ist, das Steuersignal, das dem optischen Verlustbereich zugeführt wird, zu steuern, wobei die Steuerschaltung dazu ausgelegt ist, ein periodisch variierendes Steuersignal zu erzeugen, um den optischen Verlustbereich periodisch vom geringeren Verlustmodus in den hohen Verlustmodus zu schalten, derart dass der Laser in einem Burstmodus betrieben wird, wobei die Steuerschaltung eine Ansteuerstromsteuerschaltung umfassen, die dazu ausgelegt ist, den Ansteuerstrom, der dem mindestens einen aktiven Bereich zugeführt wird, zu steuern, derart, dass eine durchschnittliche elektrische Leistung, die dem mindestens einen aktiven Bereich zugeführt wird, in einer Periode, in der der Laser das Ausgangssignal nicht emittiert, und in einer Periode, in der der Laser das Ausgangssignal emittiert, im Wesentlichen gleich ist; wobei
der Laser einen direkt modulierten Laser umfasst, wobei die Ansteuerstromsteuerschaltung dazu ausgelegt ist, den Ansteuerstrom derart zu modulieren, dass der aktive Bereich ein moduliertes optisches Signal erzeugt.

2. Laser nach Anspruch 1, wobei der steuerbare optische Verlustbereich einen Absorptionsbereich umfasst, wobei der Absorptionsbereich dazu ausgelegt ist, optische Energie einer Wellenlänge des optischen Signals im hohen optischen Verlustmodus zu absorbieren und optische Energie der Wellenlänge des optischen Signals im geringeren optischen Verlustmodus zu übertragen.

3. Laser nach Anspruch 2, wobei der Absorptionsbereich einen optischen Halbleiterverstärker umfasst, wobei der optische Halbleiterverstärker dazu ausgelegt ist, in Reaktion auf das Steuersignal zwischen einem Absorptionsmodus für einen hohen optischen Verlust und einem transparenten Modus für einen geringeren optischen Verlust zu schalten.

4. Laser nach Anspruch 3, wobei der Absorptionsbereich aus einem selben Material wie das Material des aktiven Bereichs gebildet ist, wobei der Absorptionsbereich in Sperrrichtung vorgespannt ist, wenn er sich im Absorptionsmodus befindet.

5. Laser nach einem der Ansprüche 2 bis 4, wobei der Absorptionsbereich dazu ausgelegt ist, das optische Signal im geringeren optischen Verlustmodus zu verstärken.

6. Laser nach Anspruch 1, wobei der steuerbare optische Verlustbereich eines von Folgendem umfasst: einen steuerbaren neigbaren Spiegel, der an einem Ende des resonanten Laserresonators eine Reflexionsfläche bildet, und einen steuerbaren Abschirmabschnitt zum steuerbaren Blockieren der Übertragung des optischen Signals im resonanten Laserresonator.

7. Laser nach einem der vorhergehenden Ansprüche, wobei der mindestens eine aktive Bereich das Bragg-Gitter umfasst.

8. Laser nach einem der Ansprüche 1 bis 7, wobei der resonante Resonator ferner einen reflektierenden Abschnitt für die Wellenlängenauswahl umfasst.

9. Laser nach Anspruch 8, wobei der resonante Resonator ferner einen Phasenauswahlbereich umfasst.

10. Verfahren zum Steuern einer Ausgabe eines optischen Signals von einem Laser, der einen resonanten Laserresonator umfasst, wobei der resonante Laserresonator ein Bragg-Gitter (30), wobei die Teilung des Bragg-Gitters die Wellenlängenauswahl für den Laser bereitstellt, mindestens einen aktiven Bereich (20), der ein Material umfasst, das dazu ausgelegt ist, ein optisches Signal in Reaktion auf einen Ansteuerstrom zu verstärken, und einen steuerbaren optischen Verlustbereich (10) umfasst, wobei der steuerbare optische Verlustbereich steuerbar ist, zwischen einem hohen optischen Verlustmodus und einem geringeren optischen Verlustmodus überzugehen; wobei das Verfahren Folgendes umfasst:
Zuführen eines Ansteuerstroms zum aktiven Bereich des resonanten Resonators des Lasers;
Zuführen eines periodisch variierenden Steuersignals zum optischen Verlustbereich (10) des resonanten Resonators des Lasers, wobei das Steuersignal den optischen Verlustbereich zum periodischen Übergehen zwischen einem hohen Verlust- und einem geringeren Verlustmodus steuert, wobei ein Lasereffekt des resonanten Resonators durch erhöhte optische Verluste unterdrückt wird, wenn sich der optische Verlustbereich im hohen Verlustmodus befindet, derart, dass der Laser in einem Burstmodus betrieben wird;
Steuern des Ansteuerstroms, der dem mindestens einen aktiven Bereich zugeführt wird, derart, dass eine durchschnittliche elektrische Leistung, die dem mindestens einen aktiven Bereich zugeführt wird, in einer Periode, in der der Laser das Ausgangssignal nicht emittiert, und in einer Periode, in der der Laser das Ausgangssignal emittiert, im Wesentlichen gleich ist; wobei
der Laser einen direkt modulierten Laser umfasst, wobei die Ansteuerstromsteuerschaltung den Ansteuerstrom derart moduliert, dass der aktive Bereich ein moduliertes optisches Signal erzeugt; wobei
das Übergehen von Modi des optischen Verlustbereichs den Laser veranlasst, zwischen dem Ausgeben des optischen Signals und dem Ausgeben von keinem optischen Signal überzugehen.

## Revendications

1. Laser, ledit laser comprenant :
une cavité laser résonante ;
ladite cavité laser résonante comprenant un réseau de Bragg (30), le pas du réseau de Bragg fournissant la sélection de longueurs d'onde pour le laser, au moins une section active (20) comprenant un matériau configuré pour amplifier un signal optique en réponse à un courant d'attaque, et une section de perte optique (10) commandable, ladite section de perte optique commandable étant commandable pour effectuer une transition entre un mode de perte optique élevée et un mode de faible perte optique ;
une entrée de signal de commande configurée pour fournir un signal de commande à ladite section de perte optique (10) commandable pour commander ladite section de perte optique (10) afin qu'elle effectue une transition entre ledit mode de perte optique élevée et ledit mode de faible perte optique, un effet laser de ladite cavité résonante étant supprimé par les pertes optiques lorsque ladite section de perte optique est dans ledit mode de perte optique élevée, de sorte que ladite transition de modes de ladite section de perte optique amène ledit laser à effectuer une transition entre la sortie dudit signal optique et la sortie d'aucun signal optique ; et
une circuiterie de commande configurée pour commander ledit signal de commande fourni à ladite section de perte optique, ladite circuiterie de commande étant configurée pour générer un signal de commande variant périodiquement pour commuter périodiquement ladite section de perte optique dudit mode de faible perte audit mode de perte élevée, de sorte que ledit laser fonctionne dans un mode rafale, ladite circuiterie de commande comprenant une circuiterie de commande de courant d'attaque configurée pour commander ledit courant d'attaque fourni à ladite au moins une section active, de sorte qu'une puissance électrique moyenne fournie à ladite au moins une section active soit sensiblement la même pendant une période où ledit laser n'émet pas ledit signal de sortie et pendant une période où ledit laser émet ledit signal de sortie ; dans lequel
ledit laser comprend un laser à modulation directe, ladite circuiterie de commande de courant d'attaque étant configurée pour moduler ledit courant d'attaque de sorte que ladite section active génère un signal optique modulé.

2. Laser selon la revendication 1, dans lequel ladite section de perte optique commandable comprend une section absorbante, ladite section absorbante étant configurée pour absorber l'énergie optique d'une longueur d'onde dudit signal optique lorsqu'il est dans ledit mode de perte optique élevée et pour transmettre l'énergie optique de ladite longueur d'onde dudit signal optique lorsqu'il est dans ledit mode de faible perte optique.

3. Laser selon la revendication 2, dans lequel ladite section absorbante comprend un amplificateur optique à semi-conducteurs, ledit amplificateur optique à semi-conducteurs étant configuré pour commuter entre un mode absorbant à perte optique élevée et un mode transparent à faible perte optique, en réponse audit signal de commande.

4. Laser selon la revendication 3, dans lequel ladite section absorbante est formée d'un même matériau que ledit matériau de ladite section active, ladite section absorbante étant en polarisation inverse lorsqu'elle est dans le mode absorbant.

5. Laser selon l'une quelconque des revendications 2 à 4, dans lequel ladite section absorbante est configurée pour amplifier ledit signal optique dans ledit mode de faible perte optique.

6. Laser selon la revendication 1, dans lequel ladite section de perte optique commandable comprend l'un parmi : un miroir inclinable commandable formant une surface réfléchissante à une extrémité de ladite cavité laser résonante et une partie de blindage commandable pour inhiber de manière commandable la transmission dudit signal optique dans ladite cavité laser résonante.

7. Laser selon l'une quelconque des revendications précédentes, dans lequel ladite au moins une section active comprend ledit réseau de Bragg.

8. Laser selon l'une quelconque des revendications 1 à 7, dans lequel ladite cavité résonante comprend en outre une partie réfléchissante sélective en longueur d'onde.

9. Laser selon la revendication 8, dans lequel ladite cavité résonante comprend en outre une section de sélection de phase.

10. Procédé de commande d'une sortie d'un signal optique à partir d'un laser comprenant une cavité laser résonante, ladite cavité laser résonante comprenant un réseau de Bragg (30), le pas du réseau de Bragg fournissant la sélection de longueurs d'onde pour le laser, au moins une section active (20) comprenant un matériau configuré pour amplifier un signal optique en réponse à un courant d'attaque, et une section de perte optique (10) commandable, ladite section de perte optique commandable étant commandable pour effectuer une transition entre un mode de perte optique élevée et un mode de faible perte optique ; ledit procédé comprenant :
la fourniture d'un courant d'attaque à ladite section active de ladite cavité résonante dudit laser ;
la fourniture d'un signal de commande variant périodiquement à la section de perte optique (10) de ladite cavité résonante dudit laser, ledit signal de commande commandant ladite section de perte optique afin qu'elle effectue une transition périodique entre un mode de perte élevée et de faible perte, un effet laser de ladite cavité résonante étant supprimé par les pertes optiques accrues lorsque ladite section de perte optique est dans ledit mode de perte élevée, de sorte que ledit laser fonctionne dans un mode rafale ;
la commande dudit courant d'attaque fourni à ladite au moins une section active de sorte qu'une puissance électrique moyenne fournie à ladite au moins une section active soit sensiblement la même pendant une période où ledit laser n'émet pas ledit signal de sortie et pendant une période où ledit laser émet ledit signal de sortie ; dans lequel
ledit laser comprend un laser à modulation directe, ladite circuiterie de commande de courant d'attaque modulant ledit courant d'attaque de sorte que ladite section active génère un signal optique modulé ; dans lequel
ladite transition de modes de ladite section de perte optique amène ledit laser à effectuer une transition entre la sortie dudit signal optique et la sortie d'aucun signal optique.
